# EUROPÄISCHE PATENTSCHRIFT

(11) **EP 3 588 216 B1**
(45) Veröffentlichungstag und Bekanntmachung des Hinweises auf die Patenterteilung: **25.11.2020**
(21) Anmeldenummer: 18180299.2
(22) Anmeldetag: 28.06.2018
(51) Int. Cl.: G05B 19/05, G05B 9/02

(54) **VERFAHREN UND SYSTEM ZUM FEHLERSICHEREN BEREITSTELLEN EINES ANALOGEN AUSGABEWERTES**
METHOD AND SYSTEM FOR ERROR-PROTECTED PROVISION OF AN ANALOG OUTPUT VALUE
PROCÉDÉ ET SYSTÈME DE FOURNITURE PROTÉGÉE CONTRE LES ERREURS D'UNE VALEUR DE SORTIE ANALOGIQUE

(43) Veröffentlichungstag der Anmeldung: 01.01.2020
(73) Patentinhaber: Siemens Aktiengesellschaft, 80333 München (DE)
(72) Erfinder: Maier, Mario, 92266 Ensdorf (DE)

(56) Entgegenhaltungen:
- EP-A2- 0 257 181
- DE-A1-102011 085 877
- DE-A1-102014 009 354

## Beschreibung

Die Erfindung betrifft ein Verfahren zum fehlersicheren Bereitstellen eines analogen Ausgabewertes für einen auf funktionale Sicherheit ausgelegten Steuerungsprozess, wobei der Ausgabewert von einer Steuereinheit als ein digitaler Ausgabewert vorgegeben wird.

Auch betrifft die Erfindung ein System zum fehlersicheren Bereitstellen eines analogen Ausgabewertes für einen auf funktionale Sicherheit ausgelegten Steuerungsprozess.

In der Automatisierungstechnik, insbesondere in der industriellen Fabrik- und Prozessautomatisierung, hat sich in den letzten Jahren der Bereich in dem sicherheitsgerichtete Steuerungen (Failsafe, funktionale Sicherheit) zum Einsatz kommen, immer weiter vergrößert.

Wesentlich für eine sicherheitsgerichtete Steuerung ist eine Definition eines sicheren Zustandes, dies ist in der Regel ein AUS-Zustand oder ein Bereitstellen von sicheren Ersatzwerten. AUS-Zustand bzw. das Bereitstellen von sicheren Ersatzwerten gewährleisten bei einer Maschine, das diese dann steht oder einen Zustand annimmt in dem keine Gefahr für Leib und Leben eines Bedieners herrscht.

Eine sicherheitsgerichtete Steuerung eines Prozesses erfolgt heute in den meisten Fällen mit sogenannten fehlersicheren Steuerungen (F-PLC), wobei die Erfassung der dafür notwendigen Signale bzw. Ansteuerungen von relevanten Aktoren durch digitale Ein- und Ausgabebaugruppen erfolgt. Bei digitalen Ausgabebaugruppen sind nur die beiden Zustände AUS oder EIN möglich.

In der Automatisierungstechnik kommen aber auch zudem noch häufig sogenannte analoge Regelungsprozesse vor. Auch hierfür sind fehlersichere analoge Eingabebaugruppen bekannt, mit denen analoge Signale von Sensoren fehlersicher erfasst werden können. Eine Reaktion auf diese erfassten analogen Werte erfolgt jedoch heute ebenfalls digital, d.h. durch digitale Ausgaben, eine fehlersichere Analog-Wert-Regelung ist dadurch nicht gegeben.

Die DE 10 2011 085 877 A1 offenbart ein Verfahren zum Sicherstellen, ob von einem Stellgerät empfangene Daten auch den zu dem Stellgerät gesendeten Daten entsprechen, dazu werden Stelldaten auf zwei verschiedene Arten zum Stellgerät gesendet und im Stellgerät ausgewertet.

Die DE 10 2014 009 354 A1 offenbart eine Verbesserung zu dem in DE 10 2011 085 877 A1 aufgezeigten Verfahren, wobei zusätzlich über gesendeten Daten jeweils ein Integral gebildet wird.

Die EP 0 257 181 A2 zeigt eine Vorrichtung für ein Kraftfahrzeug zur sicheren Steuerung einer Drosselklappe.

Der Erfindung liegt demnach die Aufgabe zugrunde, ein fehlersicheres analoges Ausgabemodul bereitzustellen, mit welchem eine fehlersichere analoge Regelung bis SIL3 (Safety Integrity Level) nach IEC 61508 z.B. für analoge Aktoren, wie lineare Ventile, Stellregler oder Servomotoren mit einer 0 bis 20 mA, 4 bis 20 mA, 0 bis 10 V, +/- 10 V oder vergleichbaren Schnittstellen möglich ist.

Verfahrensgemäß wird die Erfindung dadurch gelöst, dass ein Verfahren zum fehlersicheren Bereitstellen eines analogen Ausgabewertes für einen auf funktionale Sicherheit ausgelegten Steuerungsprozess, wobei der Ausgabewert von einer Steuereinheit als ein digitaler Ausgabewert vorgegeben wird, folgende Schritte umfasst:
- In einem ersten Schritt wird der digitale Ausgabewert mittels eines Umsetzmittels in den analogen Ausgabewert umgesetzt.
- In einem zweiten Schritt wird der analoge Ausgabewert unter Anwendung von Fehlersicherheits-Kriterien mittels eines Rücklesemittels in einen fehlersicheren Ausgabewert umgesetzt.
- In einem dritten Schritt wird der ursprünglich bereitgestellte digitale Ausgabewert mit dem umgesetzten fehlersicheren digitalen Ausgabewert verglichen, für den Fall, dass der Vergleich eine Abweichung ergibt oder ein Plausibilitätskriterium verletzt wird, wird eine Sicherheitsaktion ausgeführt, andererseits wird der analoge Ausgabewert mit Hilfe eines Freigabemittels an den Steuerungsprozess ausgegeben.

Fehlersicherheitskriterien bedeuten hier, dass z.B. Berechnungen zweifach-diversitär ausgeführt werden oder das entsprechende Baugruppen intern zweikanalig aufgebaut sind oder das zwei integrierte Rechen-Prozessoren sich gegenseitig überwachen. Zusätzlich wird noch ein sicherheitsgerichtetes Busprotokoll wie z.B. PROFI Safe verwendet. In der Norm 61508 sind weitere Fehlersicherheitskriterien beschrieben.

Durch das nochmalige Wandeln des analogen Wertes in einen digitalen Wert und wiederum das anschließende Rückkoppeln in die Steuerung ist es nach einer ersten alternativen Ausgestaltung möglich, in der Steuerung durch eine Plausibilitätsprüfung/bei oder einen Vergleich eine unzulässige Abweichung des Ist-Wertes von dem Soll-Wert festzustellen, und es kann bei einer Abweichung ein sicherer Zustand eingeleitet werden.

Nach einer zweiten alternativen Ausgestaltung ist vorgesehen den fehlersicheren digitalen Ausgabewert über das Rücklesemittel zweikanalig zu erzeugen und den über den ersten Kanal erzeugten fehlersicheren analogen Ausgabewert mit dem ursprünglich bereitgestellten digitalen Ausgabewert zu vergleichen und zusätzlich den über den zweiten Kanal erzeugten fehlersicheren digitalen Ausgabewert mit dem über den ersten Kanal erzeugten digitalen Ausgabewert zu vergleichen.

Erfindungsgemäß wird bei dem Verfahren als Steuereinheit eine auf funktionale Sicherheit ausgelegte speicherprogrammierbare Steuerung mit einem Sicherheitsprogramm verwendet, z.B. eine Simatic S7F mit einem sicherheitsgerichteten, fehlertoleranten Programm. Erfindungsgemäß wird als Umsetzmittel eine Analog-Ausgabe-Baugruppe verwendet als Rücklesemittel eine auf funktionale Sicherheit ausgelegte Analog-Eingabe-Baugruppe und als Freigabemittel eine auf funktionale Sicherheit ausgelegte Digital-Ausgabebaugruppe. Bei einem erfindungsgemäßen diskreten Aufbau aus drei Baugruppen wird demnach der auszugebende Analogwert mit einer Analog-Ausgabe-Baugruppe als eine Standard-Baugruppe, nämlich nicht eine auf funktionale Sicherheit ausgelegte Baugruppe, realisiert. Die für die Rückkopplung notwendige Analog-Eingabe-Baugruppe ist hingegen auf eine funktionale Sicherheit ausgelegte Spezial-Baugruppe.

Besonders vorteilhaft wird das Verfahren zur Anwendung eines fehlersicheren analogen Regelungsprozesses genutzt. Da in der Automatisierungstechnik auch häufig sogenannte analoge Regelungsprozesse vorkommen, sind hierfür ebenso fehlersicher analoge Eingabe-Baugruppen bekannt, mit denen analoge Signale von Sensoren fehlersicher erfasst werden können, die Reaktion auf diese erfassten analogen Werte erfolgt heute jedoch ebenfalls digital, d.h. durch die digitalen Ausgaben, ist eine fehlersichere Analog-Wert-Regelung bisher nicht möglich gewesen.

Die eingangs genannte Aufgabe wird ebenso durch ein System zum fehlersicheren Bereitstellen eines analogen Ausgabewertes für einen auf funktionale Sicherheit ausgelegten Steuerungsprozess gelöst. Dabei umfasst das System eine Steuereinheit, welcher einen digitalen Ausgabewert vorgibt, ein Umsetzmittel, welches den digitalen Ausgabewert in den analogen Ausgabewert umsetzt, ein Rücklesemittel, welches den analogen Ausgabewert unter Anwendung von Fehlersicherheits-Kriterien in einen fehlersicheren digitalen Ausgabewert umsetzt, ein Freigabemittel, welches ausgestaltet ist, den analogen Ausgabewert an dem Steuerungsprozess auszugeben, wenn der ursprünglich bereitgestellte digitale Ausgabewert mit dem umgesetzten fehlersicheren digitalen Ausgabewert übereinstimmt, und für den Fall, dass es eine Abweichung gibt oder ein Plausibilitätskriterium verletzt wird, wird eine Sicherheitsaktion durch die Steuereinheit ausgeführt, andererseits wird der analoge Ausgabewert mit Hilfe des Freigabemittels an den Steuerungsprozess ausgegeben.

Auch hier kann das System nach einer ersten oder zweiten Variante realisiert sein. In einer ersten Variante ist die Steuereinheit dazu ausgestaltet, den ursprünglich bereitgestellten digitalen Ausgabewert mit dem umgesetzten fehlersicheren digitalen Ausgabewert zu vergleichen, und für den Fall, dass der Vergleich eine Abweichung ergibt oder ein Plausibilitätskriterium verletzt wird, wird eine Sicherheitsaktion durch die Steuereinheit ausgeführt, andererseits veranlasst die Steuereinheit das der analoge Ausgabewert mit Hilfe des Freigabemittels an den Steuerungsprozess ausgegeben wird.

Erfindungsgemäß werden dann bei dem System diskrete Baugruppen zusammengestellt. Die Steuereinheit ist dann als eine auf funktionale Sicherheit ausgelegte speicherprogrammierbare Steuerung mit einem Sicherheitsprogramm ausgestaltet. Das Umsetzmittel ist als eine Analog-Ausgabe-Baugruppe (Standard) ausgestaltet und das Rücklesemittel ist als eine auf funktionale Sicherheit ausgelegte Analog-Eingabe-Baugruppe ausgestaltet und das Freigabemittel ist als eine auf funktionale Sicherheit ausgelegte Digital-Ausgabe-Baugruppe ausgestaltet.

Als Variante, die vom Schutzumfang der Ansprüche nicht umfasst ist, kann das System auch aus einer integrierten Baugruppen-Variante aufgebaut sein. Demnach hätte man dann nur eine fehlersichere Analog-Ausgabe-Baugruppe, welche mit der Steuereinheit zusammenarbeitet, wobei in einem fehlersicheren Analog-AusgabeModul ein Rücklesemittel angeordnet ist, welches einen ersten Kanal und einen zweiten Kanal aufweist, und weiterhin ein zweikanaliges Prüfmittel vorhanden ist, welches ausgestaltet ist einen über den ersten Kanal bereitgestellten fehlersicheren digitalen Ausgabewert mit dem ursprünglichen bereitgestellten digitalen Ausgabewert zu vergleichen und zusätzlich einen über den zweiten Kanal bereitgestellten fehlersicheren digitalen Ausgabewert mit dem fehlersicheren digitalen Ausgabewert des ersten Kanals zu vergleichen.

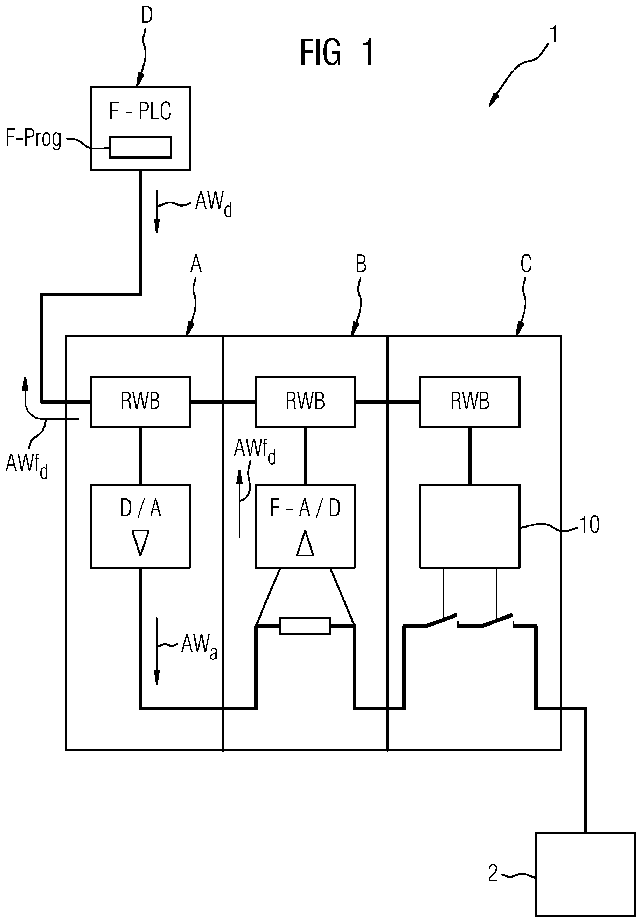

Die Zeichnung zeigt das Ausführungsbeispiel der Erfindung und die Variante. Es zeigt
- FIG 1: ein System zum fehlersicheren Bereitstellen eines analogen Ausgabewertes in einer diskreten Aufbauweise aus drei unterschiedlichen Baugruppen und
- FIG 2: das System zum fehlersicheren Bereitstellen eines analogen Ausgabewertes in einer integrierten Ausführung, wobei die Funktionalitäten in einer fehlersicheren Analog-Ausgabe-Baugruppe realisiert sind.
Gemäß der FIG 1 ist ein System 1 zum fehlersicheren Bereitstellen eines analogen Ausgabewertes AWₐ für einen auf funktionale Sicherheit ausgelegten Steuerungsprozess dargestellt. Der analoge Ausgabewert AWₐ soll letztendlich an einen Aktor 2 mit einer analogen Schnittstelle angelegt werden. Erfindungsgemäß wird der durch eine Steuereinheit D bereitgestellte digitale Ausgabewert AW_{d} mit einer Analog-Ausgabe-Baugruppe A in einen analogen Ausgabewert AWₐ gewandelt, wobei dieser gewandelte analoge Ausgabewert AWₐ mit einer fehlersicheren Analog-Eingabe-Baugruppe B zurückgelesen wird und in einen fehlersicheren digitalen Ausgabewert AWf_{d} umgesetzt wird.

Die Analog-Ausgabe-Baugruppe A und die fehlersichere Analog-Eingabe-Baugruppe B sind mittels eines Rückwandbusses RWB verbunden. Auch die Steuereinheit D kann mit den Baugruppen A,B über den Rückwandbus RWB kommunizieren.

Der durch die fehlersichere Analog-Eingabe-Baugruppe B erzeugte fehlersichere digitale Ausgabewert AWf_{d} wird der Steuereinheit D zur Verfügung gestellt, welche den ursprünglich bereitgestellten digitalen Ausgabewert AW_{d} mit dem umgesetzten fehlersicheren digitalen Ausgabewert AWf_{d} vergleicht, und für den Fall, dass der Vergleich eine Abweichung ergibt oder ein Plausibilitätskriterium verletzt wird, wird eine Sicherheitsaktion ausgeführt, andererseits wird der analoge Ausgabewert AWₐ mit Hilfe eines Freigabemittels, welches in einer fehlersicheren Digital-Ausgabe-Baugruppe C angeordnet ist, an den Steuerungsprozess ausgegeben. Demnach ist das Freigabemittel bzw. die fehlersichere Digital-Ausgabe-Baugruppe C dazu ausgestaltet auf Anweisung der Steuereinheit D den analogen Ausgabewert AWₐ an den Steuerungsprozess, beispielsweise durch einen Schalter mittels eines Ansteuermittels 10 weiter zu geben.
Für die Umsetzung von digital nach analog weist die Analog-Ausgabe-Baugruppe A einen Digital-Analog-Wandler D/A inklusive Verstärker und Pegelanpassung auf. Für die Zurückwandlung aus einem analogen Wert in einen digitalen Wert weist die fehlersichere Analog-Eingabe-Baugruppe B einen fehlersicheren Analog-Digital-Wandler F-A/D inklusive Pegelanpassung auf. In der fehlersicheren Digital-Ausgabe-Baugruppe C, welche zum einen als eine fehlersichere Digital-Ausgabe oder als eine fehlersichere Relais-Ausgabe realisiert sein kann, ist das Freigabemittel als ein (Logik)-Ansteuermittel 10 ausgestaltet, welches zwei in Serie befindliche Schalter zur Weitergabe des analogen Ausgabewertes AWₐ aufweist oder ansteuern kann.

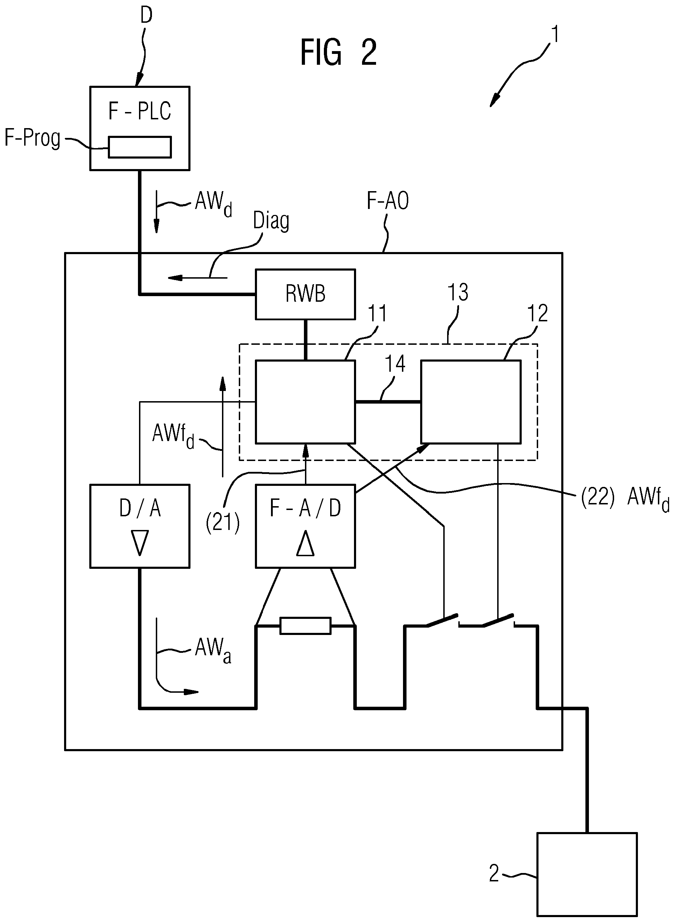

Mit der FIG 2 ist die nicht vom Schutzumfang der Ansprüche umfasste Variante des Systems 1 zum fehlersicheren Bereitstellen eines analogen Ausgabewertes AWa dargestellt. Die mit FIG 1 erklärten Funktionen für das Umsetzmittel, das Rücklesemittel und das Freigabemittel wurde gemäß FIG 1 diskret aufgebaut und sind nun gemäß FIG 2 in einer fehlersicheren Analog-Ausgabe-Baugruppe F-AO realisiert.

Die Steuereinheit D stellt wiederum einen digitalen Ausgabewert AW_{d} bereit, welcher von der Steuereinheit D über einen Rückwandbus RWB in das fehlersichere analoge Ausgabemodul F-AO geführt wird. Als Freigabemittel weist das fehlersichere analoge Ausgabemodul F-AO nun ein erstes Ansteuermittel 11 und ein zweites Ansteuermittel 12 auf. Das erste und zweite Ansteuermittel 11,12 sind in einem zweikanaligen Prüfmittel 13 eingebettet. Der fehlersichere Analog-Digital-Wandler F-AD stellt über einen ersten Kanal 21 und über einen zweiten Kanal 22 jeweils einen fehlersicheren digitalen Ausgabewert AFf_{d} zur Verfügung.

Das zweikanalige Prüfmittel ist ausgestaltet, einen über den ersten Kanal 21 bereitgestellten fehlersicheren digitalen Ausgabewert AWf_{d} mit dem ursprünglichen bereitgestellten digitalen Ausgabewert AW_{d} zu vergleichen und zusätzlich einen über den zweiten Kanal 22 bereitgestellten fehlersicheren digitalen Ausgabewert AWf_{d} mit dem fehlersicheren digitalen Ausgabewert AWf_{d} des ersten Kanals 21 zu vergleichen.

Liegt ein gültiger analoger Ausgabewert AWₐ vor, kann das erste Ansteuermittel 11 schon mal einen Schalter für die Weitergabe des analogen Ausgabewertes AWₐ schließen. Nach einer Verifikation des über den ersten Kanal 21 digital bereitgestellten digitalen Ausgabewert AW_{d} mit dem über den zweiten Kanal 22 bereitgestellten digitalen Ausgabewert AW_{d} kann das zweite Ansteuermittel 12 den zweiten Schalter zur Ausgabe des analogen Ausgabewertes AWₐ schließen und somit kann der analoge Ausgabewert AWₐ an den Aktor mit analoger Schnittstelle geführt werden. Das erste und das zweite Ansteuermittel weisen für die Verifikation eine Vergleicher-Verbindung 14 auf. Sollte einer der beiden Vergleiche fehlschlagen, so wird nicht nur der Ausgabewert AWₐ nicht freigegeben, sondern es wird zusätzlich eine Diagnosemeldung Diag zur Steuerung D gesendet.

## Patentansprüche

1. Verfahren zum fehlersicheren Bereitstellen eines analogen Ausgabewertes (AWₐ) für einen auf funktionale Sicherheit ausgelegten Steuerungsprozess, wobei der Ausgabewert (AW) von einer Steuereinheit (D) als ein digitaler Ausgabewert (AW_{d}) vorgegeben wird, und
in einem ersten Schritt der digitale Ausgabewert (AW_{d}) mittels eines Umsetzmittels in den analogen Ausgabewert (AWₐ) umgesetzt wird, in einem zweiten Schritt der analoge Ausgabewert (AWₐ) unter Anwendung von Fehlersicherheits-Kriterien, nämlich zweifach-diversitär, mittels eines Rücklesemittels in einen fehlersicheren digitalen Ausgabewert (AWf_{d}) umgesetzt wird, in einem dritten Schritt der ursprünglich bereitgestellte digitale Ausgabewert (AW_{d}) mit dem umgesetzten fehlersicheren digitalen Ausgabewert (AWf_{d}) verglichen wird, und für den Fall, dass der Vergleich eine Abweichung ergibt oder ein Plausibilitätskriterium verletzt wird, eine Sicherheitsaktion ausgeführt wird, und andernfalls der analoge Ausgabewert (AWa) mit Hilfe eines Freigabemittels an den Steuerungsprozess ausgegeben wird, wobei der fehlersichere digitale Ausgabewert (AWf_{d}) der Steuereinheit zur Verfügung gestellt wird und in der Steuereinheit mit dem digitalen Ausgabewert (AW_{d}) verglichen wird, **dadurch gekennzeichnet, dass** als Steuereinheit (D) eine auf funktionale Sicherheit ausgelegte speicherprogrammierbare Steuerung (F-PLC) mit einem Sicherheitsprogramm (F-Prog) verwendet wird, wobei als Umsetzmittel eine Analog-Ausgabe-Baugruppe (A) verwendet wird, welche als eine Standard-Baugruppe, nämlich als eine nicht auf funktionale Sicherheit ausgelegte Baugruppe realisiert wird, als Rücklesemittel eine auf funktionale Sicherheit ausgelegte Analog-Eingabe-Baugruppe (B) und als Freigabemittel eine auf funktionale Sicherheit ausgelegte Digital-Ausgabe-Baugruppe (C) verwendet wird.

2. Verfahren nach Anspruch 1, wobei der fehlersichere digitale Ausgabewert (AWf_{d}) über das Rücklesemittel zweikanalig erzeugt wird und der über einen ersten Kanal (21) erzeugte fehlersichere digitale Ausgabewert (AWf_{d}) mit dem ursprünglich bereitgestellten digitalen Ausgabewert (AW_{d}) verglichen wird und zusätzlich der über einen zweiten Kanal (22) erzeugte fehlersichere digitale Ausgabewert (AWf_{d}) mit dem fehlersicheren digitalen Ausgabewert (AWfₐ) des ersten Kanals (21) verglichen wird.

3. Verfahren nach einem der Ansprüche 1 bis 2 zur Anwendung in einem fehlersicheren analogen Regelungsprozess.

4. System (1) zum fehlersicheren Bereitstellen eines analogen Ausgabewertes (AWₐ) für einen auf funktionale Sicherheit ausgelegten Steuerungsprozess, umfassend eine Steuereinheit (D), welche dazu eingerichtet ist, einen digitalen Ausgabewert (AW_{d}) vorzugeben, ein Umsetzmittel, welches dazu eingerichtet ist, den digitalen Ausgabewert (AW_{d}) in den analogen Ausgabewert (AWₐ) umzusetzen, ein Rücklesemittel welches dazu eingerichtet ist, den analogen Ausgabewert (AWₐ) unter Anwendung von Fehlersicherheits-Kriterien, nämlich zweifach-diversitär, in einen fehlersicheren digitalen Ausgabewerte (AWf_{d}) umzusetzen, ein Freigabemittel, welches ausgestaltet ist, den analogen Ausgabewert (AWₐ) an den Steuerungsprozess auszugegeben, wenn der ursprünglich bereitgestellte digitale Ausgabewert (AW_{d}) mit dem umgesetzten fehlersicheren digitalen Ausgabewert (AWf_{d}) übereinstimmt, und für den Fall, dass es keine Übereinstimmung gibt oder ein Plausibilitätskriterium verletzt wird, eine Sicherheitsaktion auszuführen, wobei die Steuereinheit (D) dazu ausgestaltet ist, den ursprünglich bereitgestellten digitalen Ausgabewerte (AW_{d}) mit dem umgesetzten fehlersicheren digitalen Ausgabewert (AWf_{d}) zu vergleichen, und für den Fall, dass der Vergleich eine Abweichung ergibt oder ein Plausibilitätskriterium verletzt wird, eine Sicherheitsaktion auszuführen, und andernfalls zu veranlassen, dass der analoge Ausgabewert (AWₐ) mit Hilfe des Freigabemittels an den Steuerungsprozess ausgegeben wird, **dadurch gekennzeichnet, dass** die Steuereinheit (D) als eine auf funktionale Sicherheit ausgelegte speicherprogrammierbare Steuerung mit einem Sicherheitsprogramm (F-Prog) ausgestaltet ist und das Umsetzmittel als eine Analog-Ausgabe-Baugruppe (A) ausgestaltet ist, welche als eine Standard-Baugruppe, nämlich als eine nicht auf funktionale Sicherheit ausgelegte Baugruppe ausgestaltet ist und das Rücklesemittel als eine auf funktionale Sicherheit ausgelegte Analog-Eingabe-Baugruppe (B) ausgestaltet ist und das Freigabemittel als eine auf funktionale Sicherheit ausgelegte Digital-Ausgabe-Baugruppe (C) ausgestaltet ist.

5. System nach Anspruch 4, wobei das Rücklesemittel einen ersten Kanal (21) und einen zweiten Kanal (22) aufweist, und weiterhin ein zweikanaliges Prüfmittel (13) vorhanden ist, welches ausgestaltet ist, einen über den ersten Kanal (21) bereitgestellten fehlersicheren digitalen Ausgabewert (AWf_{d}) mit dem ursprünglichen bereitgestellten digitalen Ausgabewert (AW_{d}) zu vergleichen und zusätzlich einen über den zweiten Kanal (22) bereitgestellten fehlersicheren digitalen Ausgabewert (AWf_{d}) mit dem fehlersicheren digitalen Ausgabewert (AWf_{d}) des ersten Kanals (21) zu vergleichen.

## Claims

1. Method for the fail-safe provision of an analogue output value (AWₐ) for a control process designed for functional safety, wherein the output value (AW) is specified by a control unit (D) as a digital output value (AW_{d}) and,
in a first step, the digital output value (AW_{d}) is converted into the analogue output value (AWₐ) by means of a conversion means,
in a second step, the analogue output value (AWₐ) is converted into a fail-safe digital output value (AWf_{d}) using fail-safe criteria, namely in two diverse ways, by means of a read-back means,
in a third step, the originally provided digital output value (AW_{d}) is compared with the converted fail-safe digital output value (AWf_{d}), and in the event of the comparison revealing a deviation or of a plausibility criterion being infringed, a safety action is performed, and otherwise, the analogue output value (AWₐ) is output to the control process with the aid of a release means, wherein the fail-safe digital output value (AWf_{d}) is provided to the control unit and compared with the digital output value (AW_{d}) in the control unit, **characterised in that** a programmable logic control system designed for functional safety (F-PLC) with a safety program (F-Prog) is used as the control unit (D), wherein an analogue output assembly (A) is used as the conversion means, which is realised as a standard assembly, namely an assembly not designed for functional safety, an analogue input assembly (B) designed for functional safety is used as the read-back means and a digital output assembly (C) designed for functional safety is used as the release means.

2. Method according to claim 1, wherein the fail-safe digital output value (AWf_{d}) is generated by the read-back means via two channels and the fail-safe digital output value (AWf_{d}) generated via a first channel (21) is compared with the originally provided digital output value (AW_{d}) and, in addition, the fail-safe digital output value (AWf_{d}) generated via a second channel (22) is compared with the fail-safe digital output value (AWfₐ) of the first channel (21).

3. Method according to one of claims 1 to 2 for application in a fail-safe analogue regulation process.

4. System (1) for the fail-safe provision of an analogue output value (AWₐ) for a control process designed for functional safety including
a control unit (D), which is designed to specify a digital output value (AW_{d}),
a conversion means, which is designed to convert the digital output value (AW_{d}) into the analogue output value (AWₐ),
a read-back means which is designed to convert the analogue output value (AWₐ) into a fail-safe digital output value (AWf_{d}) using fail-safe criteria, namely in two diverse ways,
a release means, which is embodied to output the analogue output value (AWₐ) to the control process if the originally provided digital output value (AW_{d}) conforms to the converted fail-safe digital output value (AWf_{d}) and, in the event of there being no conformity or of a plausibility criterion being infringed, to perform a safety action, wherein the control unit (D) is embodied to compare the originally provided digital output value (AW_{d}) with the converted fail-safe digital output value (AWf_{d}) and, in the event of the comparison revealing a deviation or of a plausibility criterion being infringed, to perform a safety action and otherwise, to enable the analogue output value (AWₐ) to be output to the control process with the aid of the release means, **characterised in that**, the control unit (D) is embodied as a programmable logic control system designed for functional safety with a safety program (F-Prog) and the conversion means is embodied as an analogue output assembly (A) which is designed as a standard assembly, namely as an assembly not designed for functional safety and the read-back means is embodied as an analogue input assembly (B) designed for functional safety and the release means is embodied as a digital output assembly (C) designed for functional safety.

5. System according to claim 4, wherein the read-back means comprises a first channel (21) and a second channel (22) and furthermore a dual-channel testing means (13) is provided, which is embodied to compare a fail-safe digital output value (AWf_{d}) provided via the first channel (21) with the originally provided digital output value (AW_{d}) and in addition to compare a fail-safe digital output value (AWf_{d}) provided via the second channel (22) with the fail-safe digital output value (AWf_{d}) of the first channel (21).

## Revendications

1. Procédé de mise à disposition d'une manière sécurisée vis-à-vis d'une erreur d'une valeur (AWₐ) de sortie analogique pour un processus de commande étudié en vue d'une sécurité fonctionnelle, la valeur (AW) de sortie étant prescrite par une unité (D) de commande sous la forme d'une valeur (AW_{d}) de sortie numérique, et
dans un premier stade, on transforme la valeur (AW_{d}) de sortie numérique en la valeur (AWₐ) de sortie analogique au moyen d'un moyen de transformation,
dans un deuxième stade, on transforme la valeur (AWₐ) de sortie analogique en utilisant des critères de sécurisation vis-à-vis d'une erreur, à savoir en double diversité, au moyen d'un moyen de relecture, en une valeur (AWf_{d}) de sortie numérique sécurisée vis-à-vis d'une erreur,
dans un troisième stade, on compare la valeur (AW_{d}) de sortie numérique, mise à disposition à l'origine, à la valeur (AWf_{d}) de sortie numérique transformée et sécurisée vis-à-vis d'une erreur, et dans le cas
où la comparaison donne un écart ou un critère de vraisemblance est enfreint, on effectue une action de sécurisation et, sinon, on envoie la valeur (AWₐ) de sortie analogique au processus de commande, à l'aide d'un moyen de validation,
dans lequel on met la valeur (AWf_{d}) de sortie numérique sécurisée vis-à-vis d'une erreur à la disposition de l'unité de commande et on la compare, dans l'unité de commande, à la valeur (AW_{d}) de sortie numérique, **caractérisé en ce que** l'on utilise, comme unité (D) de commande, un automate (F-PLC) programmable, conçu en vue d'une sécurisation fonctionnelle et ayant un programme (F-Prog) de sécurisation, dans lequel on utilise, comme moyen de transformation, un module (A) d'émission analogique, que l'on utilise sous la forme d'un module normalisé, à savoir qui n'est pas réalisé sous la forme d'un module étudié en vue d'une sécurisation fonctionnelle, comme moyen de relecture, un module (B) d'entrée analogique, étudié en vue d'une sécurisation fonctionnelle, et, comme moyen de validation, un module (C) d'émission numérique, étudié en vue d'une sécurisation fonctionnelle.

2. Procédé suivant la revendication 1, dans lequel on produit en deux canaux la valeur (AWf_{d}) de sortie numérique sécurisée vis-à-vis d'une erreur par le moyen de relecture, et on compare la valeur (AWf_{d}) de sortie numérique, sécurisée vis-à-vis d'une erreur et produite par un premier canal (21), à la valeur (AW_{d}) de sortie numérique mise à disposition à l'origine et, en outre, on compare la valeur (AWf_{d}) de sortie numérique, sécurisée vis-à-vis d'une erreur et produite par un deuxième canal (22), à la valeur (AWfₐ) de sortie numérique, sécurisée vis-à-vis d'une erreur, du premier canal (21).

3. Procédé suivant l'une des revendications 1 à 2 pour l'utilisation, dans un processus de régulation analogique sécurisé vis-à-vis d'une erreur.

4. Système (1) de mise à disposition, d'une manière sécurisée vis-à-vis d'une erreur, d'une valeur (AWₐ) de sortie analogique pour un processus de commande étudié en vue d'une sécurisation fonctionnelle, comprenant
une unité (D) de commande, qui est conçue pour donner une valeur (AW_{d}) de sortie numérique,
un moyen de transformation, qui est conçu pour transformer la valeur (AW_{d}) de sortie numérique en la valeur (AWₐ) de sortie analogique,
un moyen de relecture, qui est conçu pour transformer la valeur (AWₐ) de sortie analogique en utilisant des critères de sécurisation vis-à-vis d'une erreur, à savoir en double diversité, en une valeur (AWf_{d}) de sortie numérique sécurisée vis-à-vis d'une erreur,
un moyen de validation, qui est conformé pour envoyer la valeur (AWₐ) de sortie analogique au processus de commande, si la valeur (AW_{d}) de sortie numérique, mise à disposition à l'origine, coïncide avec la valeur (AWf_{d}) de sortie numérique, sécurisée vis-à-vis de l'erreur et est transformée, et, dans le cas où il n'y a pas coïncidence ou un critère de vraisemblance est enfreint, effectuer une action de sécurisation, l'unité (D) de commande étant conformée pour comparer la valeur (AW_{d}) de sortie numérique, mise à disposition à l'origine, à la valeur (AWf_{d}) de sortie numérique, sécurisée vis-à-vis d'une erreur et transformée et, dans le cas où la comparaison donne un écart ou un critère de vraisemblance est enfreint, effectuer une action de sécurisation et, sinon, provoquer que la valeur (AWₐ) de sortie analogique soit envoyée à l'aide du moyen de validation au processus de commande,
**caractérisé en ce que** l'unité (D) de commande est conformée sous la forme d'un automate programmable, étudié en vue d'une sécurisation fonctionnelle et ayant un programme (F-Prog) de sécurisation et **en ce que** le moyen de transformation est conformé sous la forme d'un module (A) de sortie analogique, qui est conformé sous la forme d'un module normalisé, à savoir d'un module, qui n'est pas étudié pour une sécurisation fonctionnelle, et **en ce que** le moyen de relecture est conformé sous la forme d'un module (B) d'entrée analogique, étudié en vue d'une sécurisation fonctionnelle, et **en ce que** le moyen de validation est conformé sous la forme d'un module (C) d'émission numérique, étudié en vue d'une sécurisation fonctionnelle.

5. Système suivant la revendication 4, dans lequel le moyen de relecture a un premier canal (21) et un deuxième canal (22), et il y a, en outre, un moyen (13) de contrôle à deux canaux, qui est conformé pour comparer une valeur (AWf_{d}) de sortie numérique sécurisée vis-à-vis d'une erreur et mise à disposition, à la valeur (AW_{d}) de sortie numérique mise à disposition d'origine et, en outre, pour comparer une valeur (AWf_{d}) de sortie numérique, sécurisée vis-à-vis d'une erreur et mise à disposition par le deuxième canal (22), à la valeur (AWf_{d}) de sortie numérique sécurisée vis-à-vis d'une erreur, du premier canal (21).
